# EUROPEAN PATENT SPECIFICATION

(11) **EP 0 318 485 B1**
(45) Date of publication and mention of the grant of the patent: **07.04.1993**
(21) Application number: 87905027.6
(22) Date of filing: 30.06.1987
(51) Int. Cl.: H05K 3/46

(54) **APPARATUS AND METHOD FOR HIGH DENSITY INTERCONNECTION SUBSTRATES USING STACKED MODULES**
VORRICHTUNG UND VERFAHREN FUER HOCHINTEGRIERTE VERBINDUNGSSUBSTRATE UNTER VERWENDUNG VON GESTAPELTEN MODULN
APPAREIL ET PROCEDE POUR SUBSTRATS D'INTERCONNEXION A HAUTE DENSITE A L'AIDE DE MODULES EMPILES

(30) Priority: 15.08.1986 US 897393
(43) Date of publication of application: 07.06.1989
(73) Proprietor: DIGITAL EQUIPMENT CORPORATION, Maynard, MA 01754-1418 (US)
(72) Inventor: SANKAR, N., Gowri, Andover, MA 01810 (US); CZEREPAK, Stanley, Burlington, MA 01803 (US)
(74) Representative: Goodman, Christopher
(86) International application number: US8701549
(87) International publication number: WO8801469

(56) References cited:
- EP-A- 0 028 657
- EP-A- 0 064 872
- DE-A- 2 330 161
- IBM Technical Disclosure Bulletin, volume 21, no. 12, May 1979, (New York, US), O.R. Abolafia et al.: "Multilayer metalized ceramic substrate", pages 4796-4797
- IBM Technical Disclosure Bulletin, volume 11, No. 8, January 1969, (New York, US), K. Hermann: "Multilayer laminates", page 962

## Description

### BACKGROUND OF THE INVENTION

### 1. Field of the Invention

This invention relates generally to electronic circuits and more particularly to the structure of substrates, to which the electrical components are coupled, that provides the conducting paths electrically coupling the components.

### Description of the Related Art

It is known in the related art see for example IBM Technical Disclosure Bulletins Vol 11, No 8, January 1969 and Vol 21, No 12, May 1979 to fabricate interconnection structures providing the electrical coupling between electronic components in which thin film technology provides layers of conducting paths (e.g. sputtered and plated chromium copper) on top of layers of insulating dielectric material (e.g. polyimide). The interlayer conductive coupling is provided by reactive ion etching or similar dry etching techniques to provide openings (or vias) in the layers and filling the resulting openings with metal. The multilayer structure is formed on a base ceramic or similar stable material. The layers are formed one over the other with one layer processed at a time. The resulting substrate can provide a very high interconnection density and can be made hermetic by sealing the substrate. Thus, the desired substrate configuration is developed in a multiplicity of serial process steps. The usefulness of this technique for providing an interconnection structure is limited by the yield, cost and fabrication cycle time. In addition, as the thickness of the dielectric layers decreases, the interlayer capacitance increases and can limit the signal propagation in the structure.

It is also known in the related art see for example, EP-A-0064872 and EP-A-0028657 that a multilayer interconnection structure can be based on the printed wiring board technology consisting of reinforced polymer dielectric material sheets. The interlayer conducting paths are formed by mechanical drilling of the sheets and metalization of the interlayer paths by electrodeless and electroplating. The sheets are coupled by lamination techniques using polymer material to bond the layers together. This technique for providing an interconnection structure is limited by material stability, moisture absorption, feature resolution in processing the inner sheet, process limitations in drilling and plating, processing, and density and reliability problems resulting from process tolerances. To overcome these limitations, subassemblies with reduced layer count are processed as multilayer sheets assembled in the conventional manner. Because of the lower number of layers and the reduced board thickness, the length of the interlayer conducting paths can be reduced. The subassemblies can be laminated together to provide a total interconnection structure. Interconnection paths between the subassemblies can then be drilled and electroplated. This technique reduces but does not eliminate the limitations found in the conventional multilayer substrate fabrication technique.

It is also known in the related art to use hybrid technology techniques (i.e. thick film or cofired techniques) using a ceramic dielectric material and thick film conducting materials. The resulting structures are very stable, can withstand higher processing and operating temperatures and provide hermeticity. However, the technique has severe processing restrictions that limit the density of the conducting traces (and the spaces therebetween) and the vias on the interconnect substrate.

An additional characteristic of serial techniques is that discrepancies in the placement of one layer on the adjacent layer are retained or magnified when additional layers are added. Also discrepancies in the planarity of one layer are retained or magnified when additional layers are added. These characteristics result in a limitation in the number or layers that an interconnect substrate can have.

An opening (or via), in which a conductive path from one side of the layer to the other is desired, can be required only in a single layer of the substrate. The conducting path if a single substrate layer is difficult to accomplish with conventional techniques, so openings are typically drilled through all layers of the substrate. This procedure imposes design limitations because of the traces that must be routed around the the openings.

Still another limitation in serial processing techniques occurs because the substrate can be tested only at the end of the fabrication process.

A need has therefore been felt for a technique for providing interconnect substrates that can achieve high density interconnection coupling paths without the limitations on yield, number, cost and cycle time of the serial processing techniques.

### FEATURES OF THE INVENTION

It is an object of the present invention to provide an improved interconnection structure for coupling electronic components.

It is a feature of the present invention to provide an interconnection structure that is fabricated as a plurality of subassemblies and, after testing, the subassemblies are coupled in the final structure.

It is still another feature of the present invention to provide an interconnection structure that is comprised of a plurality of stacked dielectric layers, each dielectric layer separated by a gap.

It is a still further feature of the present invention to provide an interconnection structure that has a high density of conducting paths without the limited yield and cycle time resulting from multiple serial processes.

### SUMMARY OF THE INVENTION

The aforementioned and other objects are obtained, according to the present invention as claimed, by fabricating a plurality of dielectric sheets pairs. The dielectric sheets have holes drilled therein and the holes are filled with a conducting material. The sheets are then lapped to the appropriate dimensions and the conducting traces and conducting regions (or pads) are deposited on both surfaces of the dielectric sheets. A conducting bonding material (dot) is placed on conducting testing regions of a dielectric sheet to be electrically coupled to a conducting pad of an adjoining dielectric sheet. The two dielectric sheets are aligned so that the dielectric sheet conducting pads can be electrically coupled by the conducting dot. the two dielectric sheet subassembly is fired to bond the two sheets together. In a similar manner, a plurality of dielectric sheet pairs can be joined together to form a multilayer circuit board.

These and other features of the present invention will be understood upon reading of the following description along with the drawings.

### BRIEF DESCRIPTION OF THE DRAWINGS

Figure 1 is a flow diagram of the steps involved in fabricating a dielectric sheet pair for a circuit board.

Figure 2A through Figure 2H show cross-sections of the two dielectric layers illustrating the steps in the fabrication of a dielectric sheet subassembly.

Figure 3 shows a perspective view of an interconnect substrate having a plurality of dielectric sheets and illustrating the presence of coupled electrical components.

Figure 4 illustrates the effect of the air gap of the present invention providing an air dielectric medium between sets of conducting paths on the surfaces of the dielectric layers.

### DESCRIPTION OF THE PREFERRED EMBODIMENT

### 1. Detailed Description of the Figures

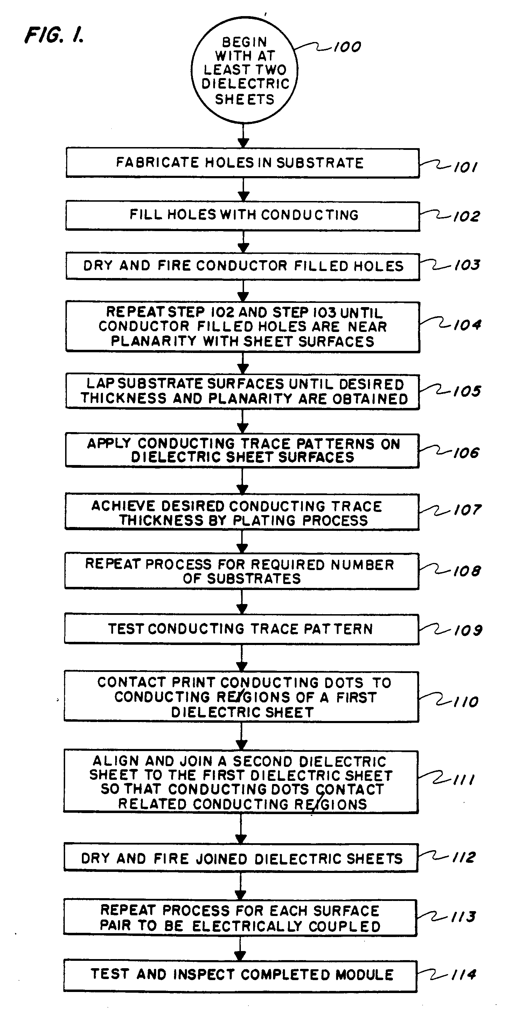

Referring now Figure 1, the fabrication of a interconnect substrate begins in step 100 with two sheets of dielectric material. In the preferred embodiment, the sheets of dielectric material are fused quartz of thickness 2 to 10 mils, however other suitable dielectric materials can be used. In step 101, holes are formed in the dielectric sheets. In the preferred embodiment, the holes are produced by a CO₂ laser and have a diameter of 1 to 4 mils. In step 103, the holes are filled with a conducting material, such as JMI 4270, produced by Johnson Matthey Electronic Materials Division, and the dielectric sheets are dried and fired to provide coupling of the fill materials to the sheet. If necessary, step 104 repeats step 103 until the fill material generally extends above the plane of the dielectric sheets. In step 105, the surface of the sheet is lapped so that the sheets have the desired thickness and flatness. In step 106, the pattern of conducting traces are deposited on the surfaces of each of the dielectric sheet using a thin film process. In the preferred embodiment, a chrome-copper seed layer is deposited. In step 107, the conducting traces are plated up to the desired thickness (by electroplating process) and conducting regions are formed. In step 108, this process is repeated for all the sheets that will comprise the final structure. In step 109, the conducting traces are tested to insure that the process has been successful. In step 110, conducting dots are contact printed to selected conducting regions of the top surface of the bottom dielectric sheet. In step 111 , the sheets are aligned (so that appropriate conducting dots of adjoining dielectric sheets are properly aligned) and the two dielectric sheets are joined. In step 112, the dielectric sheet pair is dried and fired joining the two dielectric sheets. These processes are repeated for each dielectric sheet pair to be joined in the interconnect substrate in step 113. In step 114, an inspection and electrical test of the interconnect substrate are performed.

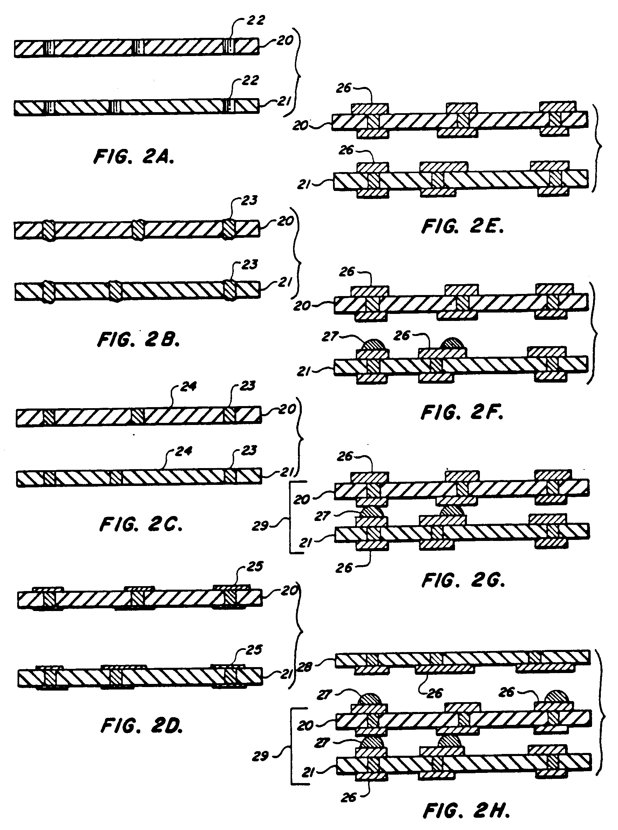

Referring next to Fig. 2A through Fig. 2B, the process steps described in Fig. 1 are illustrated by cross-sectional views of sheets of dielectric materials 20 and 21. In Fig. 2A, the holes 22 fabricated in the dielectric sheets are shown. In Fig. 2B, the filling of the holes with conducting material 23 is shown. In Fig. 2C, the result of the lapping operation sheet surfaces 24 is shown. In Fig. 2D, the process of depositing conducting seed layers 25 on the surfaces of the dielectric sheet is illustrated, while the result of the process of increasing the thickness of the conductors 26 is shown in Fig. 2E. In Fig. 2F, the placing of the conducting dots 27 on the top portion of the bottom sheet of the dielectric sheet is shown, while in Fig. 2G, the joining of the sheets and the contacting of the conducting dots 27 with the conducting regions is illustrated. A portion of the circuit board showing the coupling of dielectric sheet pairs 28 and dielectric sheet pairs 29 by means of conducting dots 27 is shown in Fig. 2H.

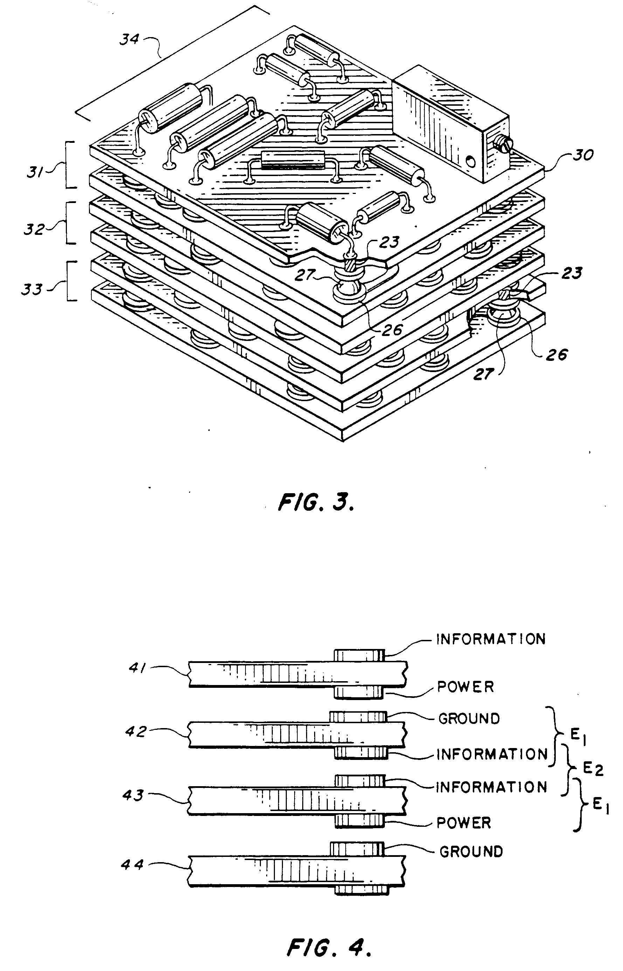

Referring to Fig. 3, an interconnection structure 30 is shown. The illustrated interconnect substrate includes dielectric sheet pairs 31, 32 and 33. The top-most sheet of the structure includes the mounting apparatus for coupling electronic components 34 to the structure 30. The spacing between the individual dielectic sheets is exaggerated for purposes of illustration and portions of the conducting dots 27 and the conductor traces 26 are displayed.

Referring next to Fig. 4, a feature of the interconnect substrate is illustrated. On sheet 41, the top conducting traces transmit information signals, while the bottom conducting traces transmit power signals. Sheet 42 has the ground potential on the top conducting traces, while the bottom traces carry information signals. On sheet 43, the top traces carry information signals, while the bottom conducting traces transmit power signals. On dielectric sheet 44, the top conducting traces maintain the ground potential, while the bottom conducting traces carry information signals. Between traces separated by a dielectric sheet, the impedance is determined by dielectric constant e₁ (for quartz, this value is approximately 3.8), while for conducting traces separated by air, the impedance and propagation delay are determined by e₂ (the dielectric constant of air is approximately 1).

### 2. Operation of the Preferred Embodiment

For the interconnect substrates of the present invention, the density of conducting traces on a surface is the same as can be achieved with thin film technology. In this technique, the ability to achieve small interlayer conducting traces of the order of 0.5-2 mils in size is important to achieve the required density. The filling of the holes with conducting material increases the cross-sectional area of the path as compared with non-filled hole techniques. This increase in cross-sectional area decreases the resistance and increases the reliability. Moreover, because each surface with traces can be tested prior to incorporation in the interconnection structure, the problem resulting from yield of multiple serial processes can be minimized by using only the defect-free dielectric sheet pairs. The dielectric sheet material and the fill material can be chosen to withstand the thermal stresses of the processing operation. These materials can also be chosen to be impervious to moisture. In addition, the structure can be hermetically sealed for additional stability.

The thickness of the dielectric sheets can be controlled by the lapping process, permitting the impedance of the conducting traces with respect to reference dielectric sheet surface conducting traces on to be precisely controlled. In Fig. 4, the dielectric material is interposed between information signals and the ground and power dielectric sheet surface conducting traces. Depending on the manner in which the signal conducting traces are referenced to the power or ground potential dielectric surface conducting traces, the option is available of using air or quartz as the dielectric medium separating the signal dielectric surface conducting traces and the reference dielectric surface conducting traces. An air dielectric medium between the signal plane and the reference plane is more appropriate for rapid signal propagation, but control of the impedance for the air dielectric medium is less precise because of the effects of moisture on the dielectric constant.

It will be clear to those skilled in the art that the technique for fabricating a interconnect substrate, according to the present invention, permits great flexibility in providing conducting paths between trace patterns on adjoining dielectric sheet surfaces. When the adjoining surfaces are on opposite sides of the a dielectric sheet, then the filled holes can be located at any position in a dielectric sheet that would be convenient for the electrical coupling, i.e. where the conducting traces to be coupled overlap on opposite sides of the dielectric sheet. Similarly, the conducting dot electrically coupling two conducting traces on dielectric sheets on opposite sides of an air gap can be positioned wherever the conducting traces overlap on the aligned dielectric sheets. In addition, a filled hole electrical coupling between conducting trace surfaces on a dielectric sheet need only be coupled by a conducting trace to the location of a conducting dot to continue the electrical coupling to conducting traces on adjoining dielectric sheet surfaces. The design of the interconnect substrate therefore has additional freedom in the location of the conducting paths (or vias) between planes of conducting traces and in the pattern of the conducting traces in each plane (i.e. dielectric sheet surface).

## Claims

1. An interconnect substrate for providing a predetermined coupling of electrical components mounted thereon, comprising first and second dielectric sheets (20, 21) said first dielectric sheet being stacked on said second dielectric sheet, each dielectric sheet having a conducting pattern (26) on each surface and a plurality of through holes (22) filled with conducting material (23) for electrically coupling the conducting pattern on one surface of each sheet to the conducting pattern on the other side of the respective sheet, and further comprising coupling means (27) for electrically coupling the conducting pattern on a surface of said first dielectric sheet to the conducting pattern on the opposing surface of said second dielectric sheet, characterized in that each of said conducting patterns comprises a plurality of conducting pads, the conducting material in each of said plurality of filled through holes having ends which are electrically connected only to the corresponding ones of said conducting pads and said coupling means having ends which are electrically connected only to the corresponding ones of said conducting pads.

2. The interconnect substrate as defined in claim 1, characterized in that some of the plurality of conducting pads on one surface of said first dielectric sheet are arranged in opposition to corresponding ones of the plurality of conducting pads on the opposing surface of said second dielectric sheet.

3. The interconnect substrate as defined in claim 2, characterized in that said coupling means comprises a plurality of conducting dots which electrically couple opposing pads on said respective dielectric sheets, said conducting dots having a predetermined thickness when sandwiched between opposing pads.

4. The interconnect substrate as defined in claim 3, characterized in that at least one pair of pads on said respective dielectric sheets are in opposition and are separated by an air gap.

5. The interconnect substrate as defined in claim 1, characterized in that the impedance of said substrate is determined by a dielectric constant of one of said sheets.

6. The interconnect substrate as defined in claim 1, characterized in that the impedance of said substrate is determined by a dielectric constant of air.

7. A process for fabricating an interconnect substrate for providing a predetermined coupling of electrical components, comprising the steps of:
forming a plurality of holes in each of first and second sheets made of dielectric material at predetermined locations on said sheets (101);
filling said holes with a conducting material (102);
applying conducting patterns with conducting pads on first and second surfaces of each of said first and second dielectric sheets (106); and
characterized by the further steps of:
placing conducting dots on preselected conducting pads on said first surface of said second dielectric sheet (110);
aligning said first surface of said second dielectric sheet with said second surface of said first dielectric sheet whereby said conducting dots are aligned with predetermined conducting pads on said second surface of said first dielectric sheet (111); and
joining said first and second dielectric sheets by said conducting dots to form an interconnect substrate dielectric sheet pair (112).

8. The method as defined in claim 7, further characterized by the step of coupling said dielectric sheet pair to a third dielectric sheet by repeating said placing step, said aligning step and said joining step.

9. The method as defined in claim 7, characterized in that said filling step includes the steps of drying and firing said fill conducting material.

10. The method as defined in claim 9, characterized in that said drying and firing steps are repeated a plurality of times until said fill conducting material is generally coplanar with said dielectric sheet.

11. The method as defined in claim 7, further characterized by the step of electrically testing the conducting traces on each dielectric sheet before said joining step.

12. The method as defined in claim 7, further characterized by the step of coupling said electrical components to said first surface of said first dielectrical sheet.

## Patentansprüche

1. Verbindungssubstrat zum Schaffen einer vorbestimmten Kopplung von elektrischen Komponenten, die darauf montiert sind, mit einer ersten und einer zweiten dielektrischen Lage (20, 21), wobei die erste dielektrische Lage auf der zweiten dielektrischen Lage gestapelt ist, wobei jede dielektrische Lage ein Leitungsmuster (26) auf jeder Fläche und eine Vielzahl von Durchgangslöchern (22) hat, die zur elektrischen Kopplung des Leitungsmusters auf einer Fläche von jeder Lage mit dem Leitungsmuster auf der anderen Seite der jeweiligen Lage mit leitendem Material (23) gefüllt sind, und weiterhin mit einer Kopplungseinrichtung (27) zum elektrischen Koppeln des Leitungsmusters auf einer Fläche der ersten dielektrischen Lage mit dem Leitungsmuster auf der entgegengesetzten Fläche der zweiten dielektrischen Lage, dadurch gekennzeichnet, daß jedes der Leitungsmuster eine Vielzahl von leitenden Kontaktstellen aufweist, daß das leitende Material in jedem der gefüllten Durchgangslöcher Enden hat, die elektrisch nur mit den entsprechenden der leitenden Kontaktstellen verbunden sind, und daß die Kopplungseinrichtung Enden hat, die nur mit den entsprechenden der leitenden Kontaktstellen elektrisch verbunden sind.

2. Verbindungssubstrat nach Anspruch 1, dadurch gekennzeichnet, daß einige der Vielzahl von leitenden Kontaktstellen auf einer Fläche der ersten dielektrischen Lage gegenüberliegend zu entsprechenden der Vielzahl von leitenden Kontaktstellen der gegenüberliegenden Fläche der zweiten dielektrischen Lage angeordnet sind.

3. Verbindungssubstrat nach Anspruch 2, dadurch gekennzeichnet, daß die Kopplungseinrichtung eine Vielzahl von leitenden Perlen aufweist, die entgegengesetzte Kontaktstellen auf den jeweiligen dielektrischen Lagen elektrisch koppeln, wobei die leitenden Perlen eine vorbestimmte Dicke haben, wenn sie zwischen entgegengesetzten Kontaktstellen geschichtet sind.

4. Verbindungssubstrat nach Anspruch 3, dadurch gekennzeichnet, daß zumindest ein Paar von Kontaktstellen auf den jeweiligen dielektrischen Lagen entgegengesetzt und durch einen Luftspalt getrennt ist.

5. Verbindungssubstrat nach Anspruch 1, dadurch gekennzeichnet, daß die Impedanz des Substrates durch eine Dielektrizitätskonstante von einer der Lagen bestimmt ist.

6. Verbindungssubstrat nach Anspruch 1, dadurch gekennzeichnet, daß die Impedanz des Substrats durch eine Dielektrizitätskonstante von Luft bestimmt ist.

7. Verfahren zum Herstellen eines Verbindungssubstrates zum Schaffen einer vorbestimmten Kopplung von elektrischen Komponenten, mit den Schritten:
Ausbilden einer Vielzahl von Löchern in jeder einer ersten und einer zweiten Lage, die aus dielektrischem Material hergestellt sind, und zwar an vorbestimmten Orten auf den Lagen (101);
Füllen der Löcher mit einem leitenden Material (102);
Aufbringen von leitenden Mustern mit leitenden Kontaktstellen auf der ersten und der zweiten Fläche von jeder der ersten und der zweiten dielektrischen Lage (106); und
gekennzeichnet durch die weiteren Schritte:
Anordnen von leitenden Perlen auf vorgewählten leitenden Kontaktstellen auf der ersten Fläche der zweiten dielektrischen Lage (110);
Ausrichten der ersten Fläche der zweiten dielektrischen Lage mit der zweiten Fläche der ersten dielektrischen Lage, wodurch die leitenden Perlen mit vorbestimmten leitenden Kontaktstellen auf der zweiten Fläche der ersten dielektrischen Lage ausgerichtet werden (111); und
Verbinden der ersten und der zweiten dielektrischen Lage durch die leitenden Perlen unter Ausbildung eines dielektrischen Verbindungssubstrat-Lagenpaares (112).

8. Verfahren nach Anspruch 7, weiterhin gekennzeichnet durch den Schritt des Koppelns des dielektrischen Lagenpaares mit einer dritten dielektrischen Lage durch Wiederholen des Anordnungsschrittes des Ausrichtungsschrittes und des Verbindungsschrittes.

9. Verfahren nach Anspruch 7, dadurch gekennzeichnet, daß der Füllschritt die Schritte des Trocknens und des Heizens des leitenden Füllmaterials aufweist.

10. Verfahren nach Anspruch 9, dadurch gekennzeichnet, daß die Trocknungs- und Heizungsschritte eine Vielzahl von Malen wiederholt werden, bis das leitende Füllmaterial generell koplanar mit der dielektrischen Lage ist.

11. Verfahren nach Anspruch 7, weiterhin gekennzeichnet durch den Schritt des elektrischen Testens der leitenden Spuren auf jeder dielektrischen Lage vor dem Verbindungsschritt.

12. Verfahren nach Anspruch 7, weiterhin gekennzeichnet durch den Schritt des Koppelns der elektrischen Komponenten mit der ersten Fläche der ersten dielektrischen Lage.

## Revendications

1. Substrat d'interconnexion pour assurer un couplage prédéterminé de composants électriques montés sur celui-ci, comprenant des première et seconde feuilles diélectriques (20,21), ladite première feuille diélectrique étant empilée sur ladite seconde feuille diélectrique, chaque feuille diélectrique comportant un dessin de dépôt conducteur (26) sur chaque surface et une pluralité de trous de passage (22) remplis d'un matériau conducteur (23) pour coupler électriquement le dessin de dépôt conducteur sur une surface de chaque feuille au dessin de dépôt conducteur de l'autre côté de la feuille respective, et comprenant en outre un moyen de couplage (27) pour coupler électriquement le dessin de dépôt conducteur sur une surface de ladite première feuille diélectrique au dessin de dépôt conducteur sur la surface opposée de ladite seconde feuille diélectrique, caractérisé en ce que chacun desdits dessins de dépôt conducteur comprend une pluralité de plots conducteurs, le matériau conducteur dans chacun de ladite pluralité des trous de passage remplis ayant des extrémités qui ne sont électriquement connectées qu'aux plots correspondants desdits plots conducteurs et ledit moyen de couplage ayant des extrémités qui ne sont électriquement connectées qu'aux plots correspondants desdits plots conducteurs.

2. Substrat d'interconnexion selon la revendication 1, caractérisé en ce que certains de la pluralité des plots conducteurs sur une surface de ladite première feuille diélectrique sont disposés en opposition par rapport aux plots correspondants de la pluralité des plots conducteurs sur la surface opposée de ladite seconde feuille diélectrique.

3. Substrat d'interconnexion selon la revendication 2, caractérisé en ce que ledit moyen de couplage comprend une pluralité de points conducteurs qui couplent électriquement les plots opposés sur lesdites feuilles diélectriques respectives, lesdits points conducteurs ayant une épaisseur prédéterminée quand ils sont en sandwich entre les plots opposés.

4. Substrat d'interconnexion selon la revendication 3, caractérisé en ce qu'au moins une paire de plots sur lesdites feuilles diélectriques respectives sont en opposition et sont séparés par un espace d'air.

5. Substrat d'interconnexion selon la revendication 1, caractérisé en ce que l'impédance dudit substrat est déterminée par la constante diélectrique d'une desdites feuilles.

6. Substrat d'interconnexion selon la revendication 1, caractérisé en ce que l'impédance dudit substrat est déterminée par la constante diélectrique de l'air.

7. Procédé pour fabriquer un substrat d'interconnexion afin d'assurer un couplage prédéterminé de composants électriques, comprenant les étapes qui consistent à :
former une pluralité de trous dans chacune des première et seconde feuilles constituées d'un matériau diélectrique à des emplacements prédéterminés sur lesdites feuilles (101);
remplir lesdits trous d'un matériau conducteur(102);
appliquer des dessins de dépôt conducteur avec des plots conducteurs sur des première et seconde surfaces de chacune desdites première et seconde feuilles diélectriques (106); et
caractérisé par les autres étapes qui consistent à:
placer des points conducteurs sur des plots conducteurs présélectionnés sur ladite première surface de ladite seconde feuille diélectrique (110);
aligner ladite première surface de ladite seconde feuille diélectrique avec ladite seconde surface de ladite première feuille diélectrique pour aligner ainsi lesdits points conducteurs avec des plots conducteurs prédéterminés sur ladite seconde surface de ladite première feuille diélectrique (111); et à
joindre lesdites première et seconde feuilles diélectriques par lesdits points conducteurs pour former une paire de feuilles diélectrique de substrat d'interconnexion (112).

8. Procédé selon la revendication 7, caractérisé en outre par l'étape qui consiste à coupler ladite paire de feuilles diélectriques à une troisième feuille diélectrique en répétant ladite étape de mise en place, ladite étape d'alignement et ladite étape de jonction.

9. Procédé selon la revendication 7, caractérisé en ce que ladite étape de remplissage comprend les étapes qui consistent à sécher et à cuire ledit matériau conducteur de remplissage.

10. Procédé selon la revendication 9, caractérisé en ce que lesdites étapes de séchage et de cuisson sont répétées plusieurs fois jusqu'à ce que ledit matériau conducteur de remplissage soit coplanaire dans son ensemble avec ladite feuille diélectrique.

11. Procédé selon la revendication 7, caractérisé en outre par l'étape qui consiste à contrôler électriquement les traces conductrices sur chaque feuille diélectrique avant ladite étape de jonction.

12. Procédé selon la revendication 7, caractérisé en outre par l'étape qui consiste à coupler lesdits composants électriques à ladite première surface de ladite première feuille diélectrique.
